# EUROPÄISCHE PATENTANMELDUNG

(11) **EP 1 448 039 A1**
(43) Veröffentlichungstag der Anmeldung: **18.08.2004**
(21) Anmeldenummer: 03003446.6
(22) Anmeldetag: 14.02.2003
(51) Int. Cl.: H05K 7/14

(54) **Installationsgerät und Installationssystem mit Installationsgerät**

(71) Anmelder: SIEMENS AKTIENGESELLSCHAFT, 80333 München (DE)
(72) Erfinder: Brandl, Wolfgang, 92224 Amberg (DE); Busch, Klaus, 92224 Amberg (DE)

(57) **Zusammenfassung**

Um ein Installationsgerät und ein Installationssystem (1,1a-11) mit zumindest einem Installationsgerät (2,2a-2h) anzugeben, die jeweils bei anschließbaren Vorrichtungen mit einer gegebenen Anzahl von Strombahnen eine rationelle Verdrahtung mit einfachen Mitteln gewährleisten, ist vorgesehen, dass das Installationsgerät (2,2a-2h) an seitenverschiedenen Anschlusskanälen mit einer Vorrichtung (5,5a-5d), einer weiteren Vorrichtung (9,9a-9d) bzw. einer dritten Vorrichtung (40) mit einer jeweils vorgebbaren Anzahl von Strombahnen kontaktierbar ist, wobei mittels einer Geräteeinheit (11) der Stromfluss in zumindest einem der Strombahnen (1L+,1M, E1-E8 bzw. 2L+,2M, A1-A8) beeinflussbar ist.

## Beschreibung

Die Erfindung bezieht sich auf ein Installationsgerät und ein Installationssystem mit zumindest einem Installationsgerät gemäß Patentanspruch 1 bzw. 14.

Aus der WO 99/23737 ist ein modular aufgebauter Verbraucherabzweig bekannt, der aus einer Abzweig-Baugruppe und einem Basis-Unterteil mit integrierten Leitungs- und/oder Bus-Abschnitten zusammengesetzt ist. Das Basis-Unterteil ist hierbei zu einem modularen Trägersystem mit einem Leitungs- und Bussystem durch Anreihung und Kontaktierung weiterer baugleicher Basis-Unterteile zur Aufnahme von weiteren Abzweig-Baugruppen oder Ein- bzw. Ausgabe-Baugruppen erweiterbar.

Es ist die Aufgabe der vorliegenden Erfindung, ein Installationsgerät und ein Installationssystem mit zumindest einem Installationsgerät anzugeben, die jeweils bei anschließbaren Vorrichtungen mit einer gegebenen Anzahl von Strombahnen eine rationelle Verdrahtung mit einfachen Mitteln gewährleisten.

Diese Aufgabe wird hinsichtlich des Installationsgeräts erfindungsgemäß durch die Merkmale des Patentanspruchs 1 und hinsichtlich des Installationssystems erfindungsgemäß durch die Merkmale des Patentanspruchs 14 gelöst; vorteilhafte Ausgestaltungen des Installationsgeräts bzw. des Installationssystems sind jeweils Gegenstand von weiteren Ansprüchen.

Anhand des Installationsgeräts mit einer vorgebbaren Anzahl von Anschlusskanälen, die sowohl an einer ersten Gerätestelle als auch an einer zweiten Gerätestelle mit korrespondierenden Strombahnen verschiedener Vorrichtungen kontaktierbar und jeweils für einen Stromfluss vorgesehen sind, wird mit zumindest einer Geräteeinheit erreicht, dass der Stromfluss je nach Anwendungsfall im Sinne einer planmäßigen Ausleitung und/oder Weiterleitung des jeweiligen Anschlusskanals der Geräteeinheit beeinflussbar ist, wobei ggf. unbelegte Strombahnen der anschließbaren Vorrichtungen verwendbar und dadurch eine rationelle - die Anzahl der Strombahnen berücksichtigende - Verdrahtung der jeweiligen Kanäle mit einfachen Mitteln gewährleistet ist.

Hinsichtlich des Installationssystems mit zumindest einem Installationsgerät, welches eine vorgebbare Anzahl von Anschlusskanälen aufweist, die sowohl an einer ersten Gerätestelle als auch an einer zweiten Gerätestelle mit verschiedenen Vorrichtungen kontaktiert sind und ihrerseits eine vorgebbare Anzahl von Strombahnen für einen Stromfluss aufweisen, ist vorgesehen, dass mittels einer Geräteeinheit der durch die Strombahnen der Vorrichtungen eingespeiste Stromfluss in zumindest einem der Anschlusskanäle der Geräteeinheit beeinflussbar ist; hierbei ist mittels der in ihrer Stromführung modifizierbaren Anschlusskanäle der Geräteeinheit eine vorrichtungsseitige, ggf. vollständige Nutzung der Strombahnen gegeben, so dass eine rationelle, also systemgerechte Verdrahtung mit einfachen Mitteln gewährleistet ist.

Vorteilhafterweise ist die Geräteeinheit als Schnittstelle ausgeführt, derart dass zumindest einer der Anschlusskanäle mittels einer elektrisch leitenden Brücke durchführbar bzw. unterbrechbar ist. Je nach Anwendungsfall ist hierbei eine bedarfsorientierte Belegung der Strombahnen durch die Schnittstelle gegeben, so dass einerseits eine variable Verdrahtung und andererseits eine hohe Nutzung erzielt ist.

Die Erfindung sowie vorteilhafte Ausgestaltungen gemäß Merkmalen der weiteren Ansprüche werden im Folgenden anhand in der Zeichnung dargestellter Ausführungsbeispiele näher erläutert; darin zeigen:
- FIG 1: ein schematisch dargestelltes Installationssystem mit einem Installationsgerät;
- FIG 2 und 3: verschiedene, ein Installationsgerät aufweisende Ausführungen des Installationssystems mit zumindest einem Versorgungs- und einem Verteilungsbaustein;
- FIG 4.1 bis 4.6: Abschnitte eines Installationsgeräts mit verschiedenen Ausprägungen;
- FIG 5 und 6: verschiedene Ausführungen des Installationssystems mit Ausprägungen eines Verteilungsbausteins;
- FIG 7 bis 10: verschiedene, zumindest ein Installationsgerät aufweisende, Ausführungen eines Installationssystems mit Versorgungs- und Verteilungsbausteinen;
- FIG 11 und 12: verschiedene Ausführungen eines Installationssystems mit einem Auswertungsbaustein;
- FIG 13 und 14: verschiedene Ausführungen des Installationssystems mit einem Auswertungsbaustein und einem Verteilungsbaustein.

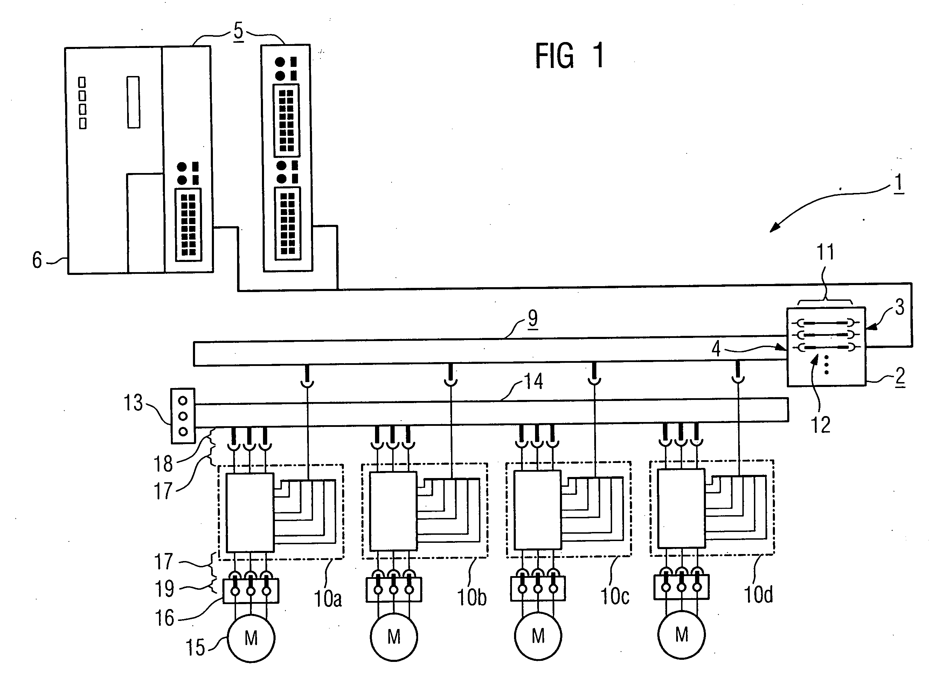

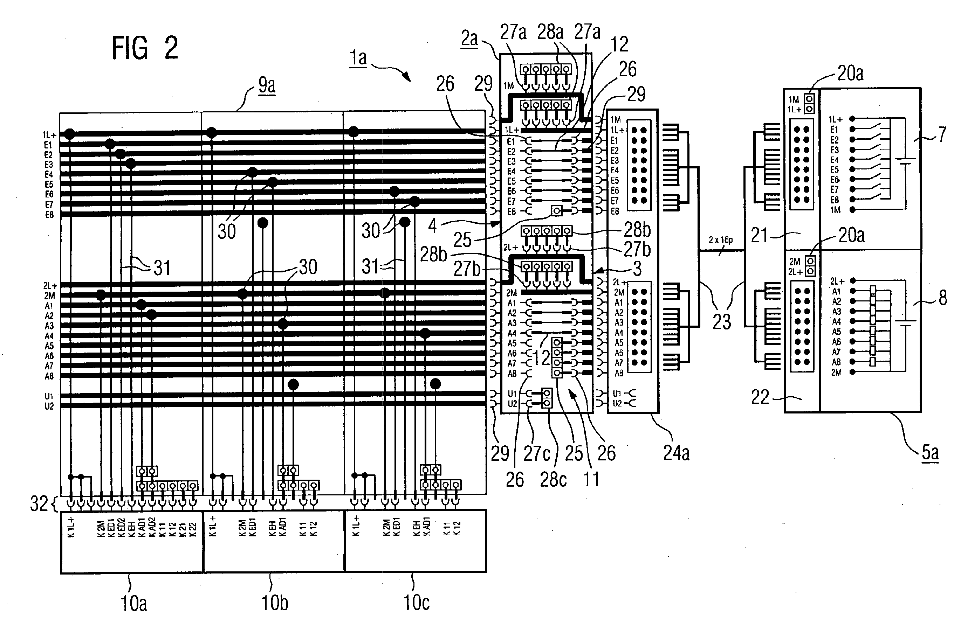

In FIG 1 ist ein schematisch dargestelltes Installationssystem 1 mit einem Installationsgerät, insbesondere Logikbaustein 2 gezeigt. Der Logikbaustein 2 weist eine vorgebbare Anzahl von Strombahnen, insbesondere Anschlusskanälen, beispielsweise gemäß FIG 2, auf. Die Anschlusskanäle - auch Brückungskanäle genannt - sind sowohl an einer ersten Gerätestelle 3 als auch an einer zweiten Gerätestelle 4 im Sinne einer Zwischenanordnung des Logikbausteins 2 kontaktierbar und jeweils für einen Stromfluss vorgesehen. Entsprechend dem vorliegenden Ausführungsbeispiel sind an den Anschlusskanälen der ersten Gerätestelle 3 zwei Vorrichtungen, insbesondere Versorgungsbausteine 5, mit einer jeweils vorgebbaren und mit der Anzahl der Anschlusskanäle korrespondieren Anzahl von Strombahnen, insbesondere Versorgungskanälen, z.B. gemäß FIG 2, angeschlossen. Der jeweilige Versorgungsbaustein 5 ist Teil einer Steuerung 6, insbesondere speicherprogrammierbare Steuerung (SPS), die über eine zentrale Recheneinheit (CPU) zur Signalverarbeitung verfügt.

Die Versorgungsbausteine 5 weisen zum einen sechszehn als Versorgungskanäle ausgeführte Eingabekanäle und zum anderen acht, ebenfalls als Versorgungskanäle ausgeführte, Ausgabekanäle auf. Über die jeweiligen Versorgungskanäle ist demnach einerseits eine Versorgung der Steuerung 6 mit Eingabesignalen und andererseits eine Versorgung zumindest einer weiteren Vorrichtung, insbesondere Verteilungsbaustein 9, mit Ausgabesignalen gegeben. Der Verteilungsbaustein 9 ist im Sinne eines Verdrahtungsbausteins mit einer vorgebbaren Anzahl von Strombahnen, insbesondere Verteilungskanälen, z.B. gemäß FIG 2, an den Anschlusskanälen des Logikbausteins 2 an der zweiten Gerätestelle 4 angeschlossen. Über die Verteilungskanäle des Verteilungsbausteins 9 sind neben einem ersten elektrischen Funktionsbaustein 10a ein zweiter, dritter und vierter elektrischer Funktionsbaustein 10b bis 10d mit einer Versorgungsspannung, insbesondere Hilfsspannung, eines Hilfsstromkreises gespeist.

Durch eine als konfigurierbare Schnittstelle ausgeführte Geräteeinheit 11 des Logikbausteins 2, ist der Stromfluss in zumindest einem der Anschlusskanäle beeinflussbar. Der jeweilige Anschlusskanal kann mittels einer elektrisch leitenden Brücke 12 durchgeführt bzw. unterbrochen werden, so dass auch unbelegte Versorgungskanäle des Versorgungsbausteins 5 und/oder Verteilungskanäle des Verteilungsbausteins 9 nutzbar sind indem an oder an Stelle der Brücke 12 zwischen den jeweiligen Kanälen Signalausleitungen und/oder Signalabzweigungen vorgenommen werden. Ebenso sind zusätzliche Signale von dem Versorgungsbaustein 5 und/oder von den Funktionsbausteinen 10a bis 10d einspeis- oder abgreifbar. Der Logikbaustein 2 übernimmt dabei im Sinne einer Auswahl bzw. Zuordnung von Strombahnen die Funktion eines Logikverteilers, der eine flexible Signalverteilung von und zu den Funktionsbausteinen 10a bis 10d gewährleistet. Der Logikbaustein 2 ist selbstverständlich an sich als auch als Teil des Installationssystems 1 vor einem Einbau bzw. vor einer Montage konfigurier- und mit Brücken bestückbar.

Neben der zugangsseitigen Speisung der Funktionsbausteine 10a bis 10d mit der Hilfsspannung ist eine Einspeisung einer weiteren Versorgungsspannung, insbesondere Hauptspannung, eines Hauptstromkreises über eine Hauptstromeinspeisung 13 einer Anschlussvorrichtung 14 vorgesehen. Abgangsseitig ist beispielsweise an dem Funktionsbaustein 10a ein Lastelement bzw. ein elektrischer Verbraucher 15 über eine weitere Anschlussvorrichtung 16 angeschlossen. Der elektrische Verbraucher 15 ist als Motor, insbesondere Drehstrommotor, ausgeführt. Sowohl zugangs- als auch abgangsseitig weist der Funktionsbaustein 10a beispielhaft Kontaktelemente 17 auf, die derart ausgebildet sind, dass Gegenkontaktelemente 18 der Anschlussvorrichtung 14 und weitere Gegenkontaktelemente 19 der weiteren Anschlussvorrichtung 16 zueinander kompatibel sind; demnach sind zum einen verschiedene, ggf. modulare Anschlussvorrichtungen an jeweils beiden Anschlussseiten gleichermaßen kontaktierbar, wobei zum anderen verschiedene Anschlusstechnologien zum Einsatz kommen können.

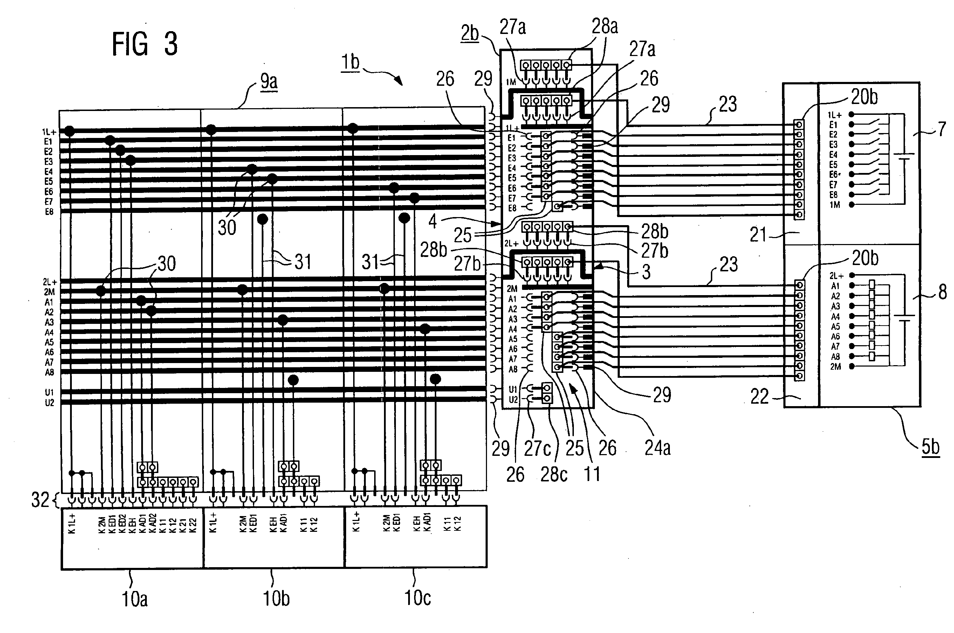

In FIG 2 und 3 sind verschiedene, den Logikbaustein 2a und 2b aufweisende Ausführungen des Installationssystems 1a und 1b mit dem Versorgungsbaustein 5a und 5b und dem jeweiligen Verteilungsbaustein 9a gezeigt. Der Versorgungsbaustein 5a und 5b umfasst zum einen einen Eingabebaustein 7, der mit einer Reihe der Versorgungskanäle versehen ist. Die Versorgungskanäle sind hierbei untergliedert in acht Eingabekanäle E1 bis E8 und in zwei Stromversorgungskanäle 1L+ und 1M. Zum anderen weist der Versorgungsbaustein 5a und 5b auch einen neben dem Eingabebaustein 7 angeordneten Ausgabebaustein 8 auf, der seinerseits ebenfalls mit einer Reihe von Versorgungskanälen ausgestattet ist. Dazu zählen acht Ausgabekanäle A1 bis A8 und zwei weitere Stromversorgungskanäle 2L+ und 2M. Die jeweiligen Stromversorgungskanäle sind über entsprechende Anschlusselemente 20a,20b kontaktiert.
Gemäß FIG 2 ist an dem Versorgungsbaustein 5a, insbesondere an dem Eingabebaustein 7, eine Anschlusseinheit 21 und, insbesondere an dem Ausgabebaustein 8, eine weitere Anschlusseinheit 22 im Sinne eines Frontsteckmoduls zur Kontaktierung der einzelnen Versorgungskanäle angeordnet. Die Anschlusseinheiten 21 und 22 sind über eine gemeinsame Leitung 23, die gemäß Ausführungsbeispiel vorkonfektioniert ist und ein Bündel mit 2 x 16 Adern aufweist, mit einem an dem Logikbaustein 2a kontaktierten Anschlussmodul 24a, insbesondere Steckanschlussmodul, im Sinne eines Adapters zur Weiterführung der jeweiligen Kanäle elektrisch leitend verbunden.

Neben der vorkonfektionierten Leitung 23, die u.a. mit gebündelten Einzeladern bzw. als Flachbandleitung oder dergleichen ausführbar ist, sind auch die Anschlusseinheiten 21,22 und das Anschlussmodul 24a zusammen mit der Leitung 23 als vorkonfektionierte Einheit ausgeführt. Alternativ dazu besteht die Möglichkeit das Anschlussmodul 24a mit den Anschlusseinheiten 21,22 manuell mittels Einzeladern zu verdrahten. Die Anschlusseinheiten 21,22 und das Anschlussmodul 24a verfügen hierbei über Steckanschlüsse, die ein komfortables Kontaktieren ermöglichen. Die 32 Einzeladern bzw. -phasen sind hälftig für den Eingabebaustein 7 und einen korrespondierenden ersten Teil des Logikverteilers 2a sowie für den Ausgabebaustein 8 und einen korrespondierenden zweiten Teil des Logikverteilers 2a vorgesehen.

Gemäß FIG 3 ist eine Ausführungsvariante gezeigt, die es gegenüber der Ausführungsvariante nach FIG 2 erlaubt, die Einund Ausgabebausteine 7 und 8 mit den daran ansteckbaren Anschlusseinheiten 21,22 unmittelbar, also ohne den Einsatz eines Anschlussmoduls, über die Leitung 23 mit dem Logikbaustein 2b elektrisch leitend zu verbinden. Die Anschlusseinheiten 21 und 22 sind jeweils mit den als mehrpolige Anschlussklemmen ausgeführten Anschlusselementen 20b, insbesondere, versehen. Mittels der Anschlusselemente 20b sind gemäß vorliegendem Ausführungsbeispiel 20 Einzeladern bzw. -phasen im Sinne der Leitung 23, inklusive der beiden Stromversorgungskanäle 1L+,1M bzw. 2L+,2M, individuell an einer Leitungsseite kontaktiert. Die Einzeladern sind an ihrer anderen Leitungsseite an Anschlussmittel 25 angeschlossen, die in dem Logikbaustein 2b angeordnet sind.

Der Logikbaustein 2a und 2b gemäß FIG 2 und FIG 3 bzw. die jeweilige Geräteeinheit 11 ist mit Kontaktstellen 26 zur Kontaktierung der Brücken 12 gemäß FIG 2 bzw. zur Kontaktierung der Anschlussmittel 25 gemäß FIG 3 versehen. Die Kontaktierung der Brücken 12 ist zwischen jeweils zwei sich gegenüberliegenden Kontaktstellen 26 gegeben. Die Anschlussmittel 25 sind hingegen wahlweise an Kontaktstellen 26 angeschlossen, die mit dem Versorgungsbaustein 5a,5b gemäß FIG 2,3 oder mit dem jeweiligen Verteilungsbaustein 9a elektrisch leitend verbunden sind, so dass je nach Einsatzzweck eine geeignete Verschaltung vorgenommen werden kann. Dabei sind Signale an dem entsprechenden Versorgungsbaustein 5a,5b oder an dem jeweiligen Verteilungsbaustein 9a einspeis- und/oder abgreifbar.

Die Geräteeinheit 11 ist hierbei mittels der Brücken 12 als Schnittstelle im Sinne von Signalunterbrechungsstellen ausgeführt. Durch die Brücken 12 sind dabei Anschlusskanäle, die mit den Versorgungskanälen korrespondieren, einerseits durchlassbar oder auch freigebbar bzw. auftrennbar. Die Anschlusskanäle sind zum einem in acht Eingabekanäle E1 bis E8 und in zwei Stromversorgungskanäle 1L+ und 1M sowie zum anderen in acht Ausgabekanäle A1 bis A8 und zwei weitere Stromversorgungskanäle 2L+ und 2M untergliedert. Der Logikbaustein 2a,2b gemäß FIG 2,3 ist mit mehreren Kontaktstellenpaaren 27a bis 27c zur Kontaktierung weiterer Anschlussmittel 28a bis 28c ausgestattet, über die verschiedene Versorgungsspannungen einspeisbar bzw. abgreifbar sind.

Dabei steht ein erstes und eine zweites Kontaktstellenpaar 27a und 27b für eine erste bzw. für eine zweite Versorgungsspannung sowie ein drittes Kontaktstellenpaar 27c für eine dritte Versorgungsspannung zur Verfügung. Die Versorgungsspannungen sind in ihrer Höhe selbstverständlich entsprechend den gegebenen Systemanforderungen einstellbar. Die dritte Versorgungsspannung ist auf entsprechende Spannungsversorgungskanäle U1 und U2 geführt. Gemäß den Ausführungsbeispielen nach FIG 2 und FIG 3 sind die Anschlussmittel 25 und die weiteren Anschlussmittel 28a bis 28c vorteilhafterweise modular und abnehmbar ausgebildet, so dass verschiedene bzw. unterschiedliche Anschlusstechnologien zum Einsatz kommen können.

Der Logikbaustein 2a,2b ist an sich mit einem Gehäuse in der Art eines Moduls versehen, das an der ersten Gerätestelle 3 und an der zweiten Gerätestelle 4 weitere Kontaktstellen 29 zur Kontaktierung zumindest einer der Versorgungskänale einerseits und zumindest einer der Verteilungskanäle andererseits für zumindest einen der Anschlusskanäle aufweist. Die Kontaktstellen 26, die Kontaktstellenpaare 27a bis 27c und die weiteren Kontaktstellen 29 sind als Steckkontakte ausgeführt, wobei z.B. eine Kontaktvariante als Klemmkontakt oder dergleichen vorgesehen werden kann. Der Logikbaustein 2a,2b ist neben dem elektrischen Anschluss zwischen dem Versorgungsbaustein 5a,5b und dem Verteilungsbaustein 9 auch mechanisch an einem der Bausteine anordbar. Die Verteilungskanäle des Verteilungsbausteins 9a sind, entsprechend den Versorgungs- und Anschlusskanälen, zum einem in acht Eingabekanäle E1 bis E8 und in zwei Stromversorgungskanäle 1L+ und 1M sowie zum anderen in acht Ausgabekanäle A1 bis A8 und zwei weitere Stromversorgungskanäle 2L+ und 2M untergliedert. Selbstverständlich kann ein Vielfaches der vorhandenen Kanalebenen, beispielsweise weitere acht, sechszehn und/oder zweiunddreißig Eingabe- und/oder Ausgabekanäle, und ggf. zugehöriger Stromversorgungskanäle vorgesehen werden.

Der Verteilungsbaustein 9a gemäß den beiden Ausführungsbeispielen nach FIG 2 und FIG 3 ist als Baugruppe mit drei Bereichen in einer vorgebbaren Baubreite ausgeführt, die sich an den Baubreiten rasterlos anschließbarer Funktionsbausteine orientiert. Die Gruppierung z.B. der Schaltgeräte an dem Verteilungsbaustein 9a ist demzufolge beliebig durchführbar, da die Verteilungskanäle durchgängig über die Länge der durch die Schaltgeräte gebildeten Funktionsbaugruppe ausgeführt sind. Mit Vorteil sind Abgriffe 30 an den Verteilungskanälen vorgesehen, welche die Verteilungskanäle mit Leiterbahnen 31 elektrisch leitend verbinden. Die als Schienen, Leiterplattenbahnen, Einzelleiter oder auch Flachbandleiter ausführbaren Leiterbahnen 31 führen einzeln oder zusammengeschaltet über Verbindungsstellen 32, die als Steckanschlüsse ausgeführt sind, zu den Funktionsbausteinen 10a bis 10c. Die Funktionsbausteine 10a bis 10c sind hierbei als Motorstarter, der Funktionsbaustein 10a insbesondere als Wendestarter und die Funktionsbausteine 10b,10c insbesondere als Direktstarter, ausgeführt. Ein Motorstarter weist insbesondere eine Kombination aus einem Leistungsschalter und einem Schütz auf. Ein Wendestarter ist durch zwei Drehrichtungen und ein Direktstarter durch eine Drehrichtung charakterisiert.

An den Funktionsbausteinen 10a bis 10c - hier als Schaltgeräte ausgeführt - sind jeweils vollständig oder vereinzelt eine Reihe von Kontakten K1L+ und K2M, KED1 und KED2, KEH, K11 und K12, K21 und K22 sowie KAD1 und KAD2 vorgesehen, an denen die entsprechenden Leiterbahnen 31 angeschlossen sind. Der Kontakt K1L+ ist für Rückmeldungen von Hilfsschaltern vorgesehen. Der Kontakt K2M dient als gemeinsamer Masseanschluss für eine Ansteuerung der Schaltgeräte. Über die Kontakte KED1 und KED2 wird jeweils ein Rückmeldesignal eines Hilfsschalters hinsichtlich des Schaltzustandes - erste Drehrichtung bzw. zweite Drehrichtung - des jeweiligen Schaltgerätes ausgegeben. Beide Kontakte KED1 und KED2 stehen letztlich jeweils über Leiterbahnen und Kanäle mit einem Eingabekanal der Versorgungsbaugruppe 5a und 5b gemäß FIG 2 und FIG 3 in Verbindung.

Über den Kontakt KEH ist die Funktion vorgesehen, ein Rückmeldesignal des Schaltzustandes des Leistungsschalters - Auslösung bzw. Handhabung - auf einen Eingabekanal des Versorgungsbaugruppe 5 weiterzuleiten. Die Kontakte K11,K12 und K21,K22 dienen jeweils zur Ausgabe eines weiteren Rückmeldesignals eines ersten bzw. eines zweiten Hilfsöffners für die erste Drehrichtung bzw. für die zweite Drehrichtung. Gemäß FIG 2 und FIG 3 stehen diese Kontakte nicht mit einem Kanal des Versorgungsbausteins 5a,5b in Verbindung. Über die Kontakte KAD1 und KAD2 ist jeweils eine elektrisch leitende Verbindung mit Schützspulen der jeweiligen Schaltgeräte vorgesehen, so dass über entsprechende Ausgabekanäle des Versorgungsbausteins 5a,5b eine Ansteuerung für die erste Drehrichtung bzw. für die zweite Drehrichtung erfolgen kann.

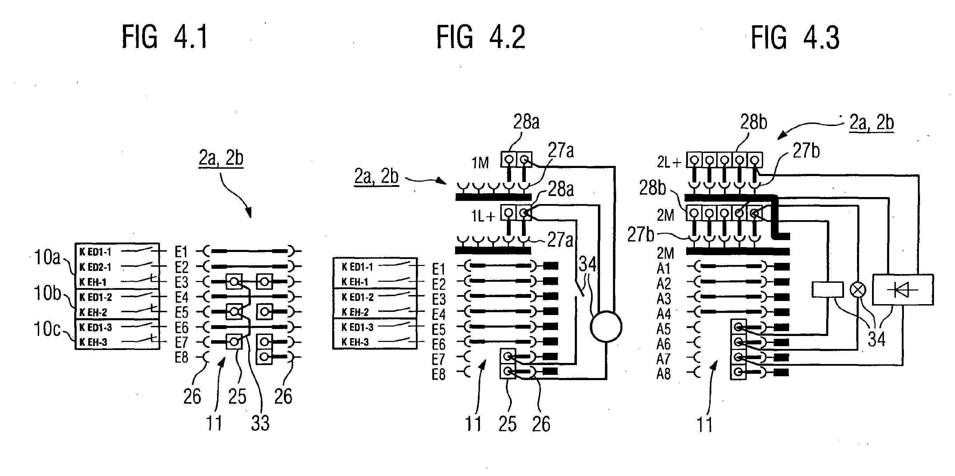

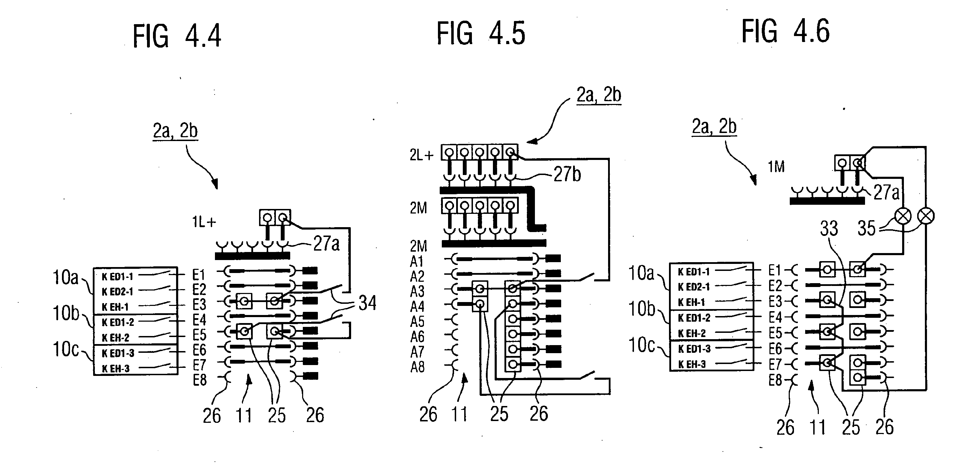

In FIG 4.1 bis FIG 4.6 ist das Installationsgerät, insbesondere jeweils ein Teil des Logikbausteins 2a,2b und/oder ein Teil der Geräteeinheit 11 gemäß FIG 2,3, mit verschiedenen Ausprägungen gezeigt. Nach FIG 4.1 ist die Geräteeinheit 11 mit einer elektrisch leitenden Verbindung 33 versehen, die zwischen den Kontaktstellen 26 des gebrückten Eingabekanals E3 und den funktionsbausteinseitigen Kontaktstellen 26 der ungebrückten Eingabekanäle E5 und E7 mittelbar über die Anschlussmittel 25 angeordnet ist. Die Eingabekanäle E3, E5 bzw. E7 sind hierbei funktionsbausteinbezogen mit dem Kontakt KEH des Funktionsbausteins 10a, mit dem Kontakt KEH des Funktionsbausteins 10b bzw. mit dem Kontakt KEH des Funktionsbausteins 10c elektrisch leitend verbunden. Die Kontakte KEH der schematisch dargestellten Funktionsbausteine 10a bis 10c sind jeweils als Hilfsöffner ausgeführt. Vorteilhafterweise wird dabei im Sinne einer Sammelmeldung bzw. eines Summensignals erkannt, wenn mindestens ein Leistungsschalter der Funktionsbausteine 10a bis 10c in AUS-Stellung ist. Die dadurch unbelegten Eingabekanäle E5 und E7 stehen zum Anschluss externer Mittel zur Verfügung.

In FIG 4.2 sind zwei geräteexterne Funktionselemente 34 vorgesehen, die als Sensor, insbesondere Hilfsschalter bzw. berührungsloser Näherungsschalter, ausgeführt sind. Der Hilfsschalter ist dabei zwischen einem der Kontaktstellen des ersten Kontaktstellenpaares 27a mittelbar über das zugehörige weitere Anschlussmittel 28a und der versorgungsbausteinseitigen Kontaktstelle 26 des ungebrückten Eingabekanals E7 mittelbar über das Anschlussmittel 25 angeschlossen ist. Der Näherungsschalter weist drei Abgänge auf, wovon zur Spannungsversorgung der erste und der zweite Abgang mit dem ersten Kontaktstellenpaar 27a mittelbar über die zugehörigen weiteren Anschlussmittel 28a elektrisch leitend verbunden sind. Der dritte Abgang des Näherungsschalters ist ebenfalls mittelbar, das heißt über das Anschlussmittel 25, mit der versorgungsbausteinseitigen Kontaktstelle 26 des ungebrückten Eingabekanals E8 angeschlossen. Bei dieser Ausführungsvariante sind die Eingabekanäle E7 und E8 in dem Logikbaustein 2a seitens des Verteilungsbausteins 9a z.B. gemäß FIG 2 nicht belegt, so dass vorteilhafterweise die vorgenannten Funktionselemente 34 angeschlossen werden können. Die dabei aufkommenden Signale werden über den Eingabebaustein 7 z.B. gemäß FIG 2 durch die Steuerung 6 gemäß FIG 1 eingelesen.

In FIG 4.3 sind, ausgehend von dem zweiten Kontaktstellenpaar 27b, den zugehörigen weiteren Anschlussmitteln 28b sowie von den ungebrückten Ausgabekanälen A5 bis A8, die Funktionselemente 34, insbesondere Aktoren, analog zu den an den Eingabekanälen E7 und E8 angeschlossenen Sensoren gemäß FIG 4.1 vorgesehen. Die Aktoren sind hierbei als Schütz, Sanftstarter, Meldeleuchte sowie ggf. als Magnetventil beispielhaft ausgebildet. Das Schütz, insbesondere Gleichstromschütz, die Meldeleuchte als auch das Magnetventil sind entsprechend dem Hilfsschalter gemäß FIG 4.2 und der Sanftstarter entsprechend dem Näherungsschalter ebenfalls gemäß FIG 4.2 angeschlossen.

Mit Vorteil sind auch hier die freien Ausgabekanäle A5 bis A8 durch den Anschluss geräteexterner Aktoren nutzbar gemacht.

In den FIG 4.4 und FIG 4.5 ist jeweils die Belegung eines gebrückten und eines ungebrückten Anschlusskanals des Logikbausteins 2a,2b gemäß FIG 2,3 gezeigt. Nach FIG 4.4 ist eines der als Hilfsschalter ausgeführten Funktionselemente 34 zwischen einem der Kontaktstellen des ersten Kontaktstellenpaares 27a und einem der Kontaktstellen 26 des gebrückten Eingabekanals E3 mittelbar gemäß FIG 4.2 angeschlossen. Gleiches gilt für den Hilfsschalter gemäß FIG 4.5, der zwischen einem der Kontaktstellen des zweiten Kontaktstellenpaares 27b und einem der Kontaktstellen 26 des gebrückten Ausgabekanals A3 mittelbar gemäß FIG 4.3 angeschlossen ist.

Bei der Belegung des ungebrückten Eingabekanals E5 gemäß FIG 4.4 und des ungebrückten Ausgabekanals A5 gemäß FIG 4.5 ist der Anschluss des jeweiligen Hilfsschalters zwischen den kanalgleichen Kontaktstellen 26 mittelbar durch die Anschlussmittel 25 gegeben. Mit beiden Ausführungsvarianten ist vorteilhafterweise eine Verknüpfung von Signalen aus den Funktionsbausteinen 10a bis 10c bzw. von Steuersignalen des Versorgungsbausteins 5a z.B. gemäß FIG 2 mit externen Hilfsschaltern erzielbar. Dabei ist es möglich logische UND-, ODER-Verknüpfungen vorzusehen.

In FIG 4.6 ist je Verschaltungsvariante ein geräteinternes und/oder geräteexternes Anzeigemittel 35 gezeigt. Hierbei ist eines der Anzeigemittel 35 zum einen zwischen einem der Kontaktstellen des ersten Kontaktstellenpaares 27a und einem der Kontaktstellen 26 des gebrückten Eingabekanals E1 angeschlossen. Zum anderen ist das jeweils andere Anzeigemittel 35 zwischen einem der Kontaktstellen des ersten Kontaktstellenpaares 27a und der elektrisch leitenden Verbindung 33 angeschlossen, die seitengleiche Kontaktstellen 26 verschiedener ungebrückter Eingabekanäle E3, E5 und E7 kontaktiert. Die Kontaktierungen sind auch nach diesen Ausführungsbeispielen mittelbar über die entsprechenden Anschlussmittel 25 ausgeführt.

Mit Vorteil ist die elektrisch leitende Verbindung 33 an den Anschlussmitteln 25 angeschlossen, die als modulare Anschlussklemmen mit einem Zweileiteranschluss ausgeführt sind. Ein genereller Vorteil der vorliegenden Ausführungsvariante besteht darin, dass Signale aus den Funktionsbausteinen 10a bis 10c über den Verteilungsbaustein 9a direkt aus dem Logikbaustein 2a und 2b gemäß FIG 2 und FIG 3 herausgeführt werden können. Dabei werden die Signale bei dem gebrückten Eingabekanal E1 an den jeweiligen Versorgungsbaustein 5a,5b und folglich auch an die Steuerung 6 gemäß FIG 1 weitergeleitet. Dies ist für die Signale der Eingabekanäle E3, E5 und E7 nicht vorgesehen ist, so dass die jeweils gegenüberliegenden Anschlussmittel 25 bzw. Kontaktstellen 26 zur freien Verfügung stehen. Selbstverständlich sind die Eingabekanäle entsprechend den FIG 4.4 und 4.5 im Sinne von logischen UND- bzw. ODER-Verknüpfungen verschaltbar.

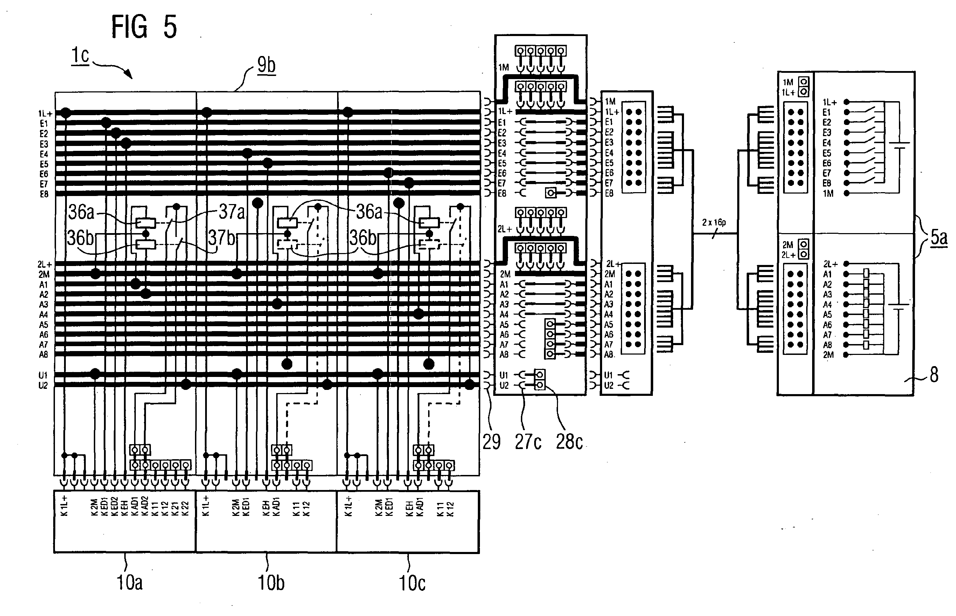

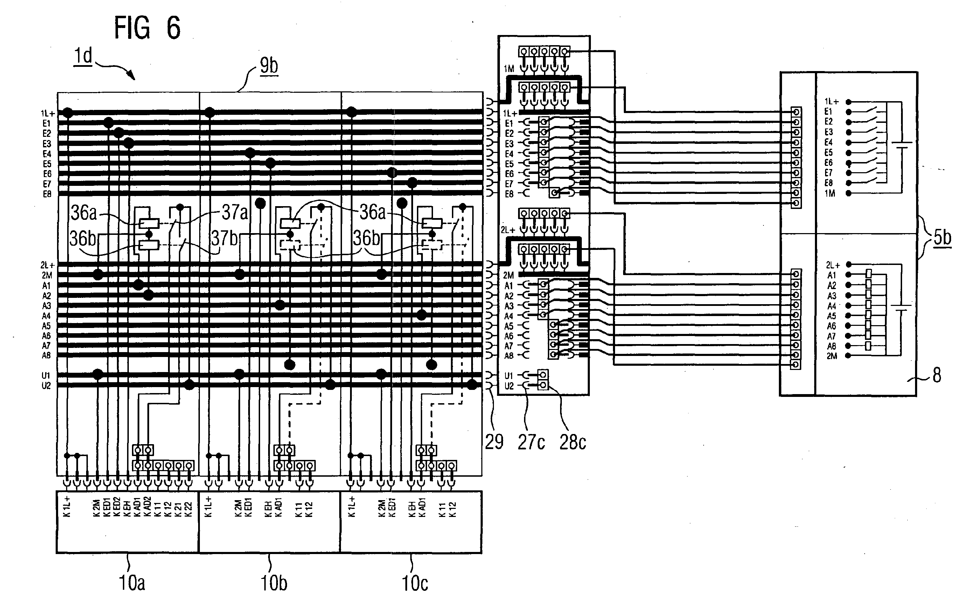

In den FIG 5 und 6 sind verschiedene Ausführungen des Installationssystems 1c und 1d mit Ausprägungen des Verteilungsbausteins 9b und des Versorgungsbausteins 5a,5b gemäß FIG 2,3 gezeigt. Die beiden Ausführungsvarianten des Installationssystems 1c und 1d unterscheiden sich in der Ausführung der Kanalverdrahtung zwischen dem Versorgungsbaustein 5a und 5b und dem Logikbaustein 2a und 2b entsprechend den Ausführungen gemäß FIG 2 und FIG 3. Der jeweilige Verteilungsbaustein 9b der beiden Installationssysteme 1c und 1d weist im Bereich des ersten Funktionsbausteins 10a an den Verteilungskanälen angeschlossene Koppelbausteine, insbesondere ein erstes und ein zweites Koppelrelais 36a und 36b, zur Ansteuerung der Schaltgeräte auf. Die Koppelbausteine können je nach Systemanforderung in dem Verteilungsbaustein 9b für einzelne oder mehrere Schaltgeräte einer Gruppe gezielt eingesetzt werden.

Die beiden Koppelrelais 36a und 36b, die auch als elektronische Koppelbausteine ausführbar sind, betätigen unabhängig voneinander jeweils zugehörige Schaltkontakte 37a und 37b. Die Spulen des ersten und des zweiten Koppelrelais 36a und 36b sind hierbei an einer Anschlussseite gemeinsam auf den Stromversorgungskanal 2M, das heißt auf Masse, gelegt. An der anderen Anschlussseite des ersten Koppelrelais 36a ist der erste Ausgabekanal A1 und an der anderen Anschlussseite des zweiten Koppelrelais 36b ist der zweite Ausgabekanal A2 aufgelegt. Die beiden Ausgabekanäle sind mittels des Logikbausteins 2a,2b und des Ausgabebausteins 8 auf die Steuerung 6 gemäß FIG 1 geführt und werden von dieser mit Signalen versorgt.

Die Schaltkontakte 37a und 37b sind gemeinsam im Sinne eines Stromzuführungsanschluss mit dem Stromversorgungskanal U2 elektrisch leitend verbunden. Abgangsseitig ist der Schaltkontakt 37a des ersten Koppelrelais 36a auf den Kontakt KAD1 des ersten Funktionsbausteins 10a geführt. Analog ist der zweite Schaltkontakt 37b des zweiten Koppelrelais 36b mit dem Kontakt KAD2 des ersten Funktionsbausteins 10a verbunden. Der jeweilige Stromkreis des ersten Funktionsbausteins 10a ist dabei über Abgriffe an dem Stromversorgungskanal U1 geschlossen, wobei die dritte Versorgungsspannung genutzt ist. Die dritte Versorgungsspannung wird über die weiteren Anschlussmittel 28c auf das zugehörige dritte Kontaktstellenpaar 27c eingespeist. Mittels der verteilungsbausteinseitigen weiteren Kontaktstellen 29 ist eine Kontaktierung der entsprechenden Spannungsversorgungskanäle U1 und U2 gegeben.

Das jeweils in dem Bereich des zweiten und des dritten Funktionsbausteins 10b und 10c angeordnete und angeschlossene Koppelrelais 36a ist entsprechend dem vorgenannten Einsatzzweck ausgeführt. Lediglich die Ansteuerung der Koppelrelais 36a erfolgt über den dritten bzw. vierten Ausgabekanal A3 bzw. A4. Das jeweilige zweite Koppelrelais 36b ist in beiden zugehörigen Bereichen optional, das heißt je nach Ausstattung des Funktionsbausteins, vorsehbar. Sofern ein Startsignal von der Steuerung 6 gemäß FIG 1 zum Schalten ausgegeben wird, erfolgt eine Ansteuerung der Spule des jeweiligen Koppelbausteins. Der Koppelbaustein schaltet in der Folge über die Ansteuerleistung des Ausgabebausteins 8 die Versorgungsspannung zu, so dass der Kontakt KAD1 - auch Starteingang genannt - eines Motorstarters beaufschlagt wird. Das zugehörige Schütz wird erregt und schaltet die Hauptspannung zum Starten eines der Elektromotoren z.B. gemäß FIG 1 zu. Selbstverständlich können die Verschaltungsvarianten mit den entsprechenden Signalrückmeldungen über die jeweiligen Schaltzustände gemäß den FIG 4.1 bis 4.6 auch bei den Ausführungen gemäß FIG 5,6 eingesetzt werden.

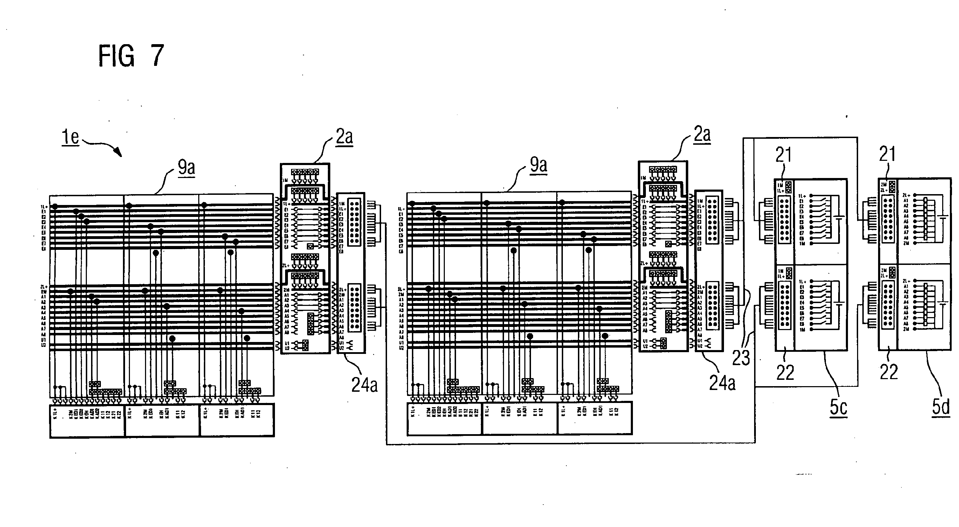

In den FIG 7 bis 10 sind vorteilhafte Ausgestaltungen des Installationssystems 1e bis 1h gezeigt, die verschiedene Ausführungen des Logikbausteins 2a und 2c bis 2f, des Versorgungsbausteins 5a, 5c und 5d sowie des Verteilungsbausteins 9a aufweisen. Gemäß FIG 7 ist eine vorteilhafte Ausführungsvariante des Installationssystems 1e gezeigt, wobei zwei baugleiche, jedoch separat und baulich getrennt ausgeführte Verteilungsbausteine 9a mit jeweils einem baugleichen Logikbaustein 2a im Sinne einer ersten und einer zweiten Funktionsgruppe verbunden sind. Die Anschlusskanäle des einen Logikbausteins 2a sind mittels dem Anschlussmodul 24a und der vorkonfektionierten Leitung 23 auf die beiden Anschlusseinheiten 22 des Versorgungsbausteins 5c und 5d geführt.

Ferner stehen die Anschlusskanäle des anderen Logikbausteins 2a mittels dem zugehörigen Anschlussmodul 24a und der entsprechenden vorkonfektionierten Leitung 23 mit den beiden Anschlusseinheiten 21 des Versorgungsbausteins 5c und 5d in einer elektrisch leitenden Verbindung. Die an den entsprechenden Versorgungsbausteinen 5c,5d angesteckten Anschlusseinheiten 21,22 sind hinsichtlich der ersten Funktionsgruppe für zwei mal acht Eingabekanäle und hinsichtlich der zweiten Funktionsgruppe für zwei mal acht Ausgabekanäle bestimmt. Die Topologie der beiden Funktionsgruppen entspricht hierbei jeweils dem prinzipiellen Aufbau des Installationssystems 1a gemäß FIG 2, wobei eine Ansteuerung über die gemeinsame Steuerung 6 gemäß FIG 1 gegeben ist.

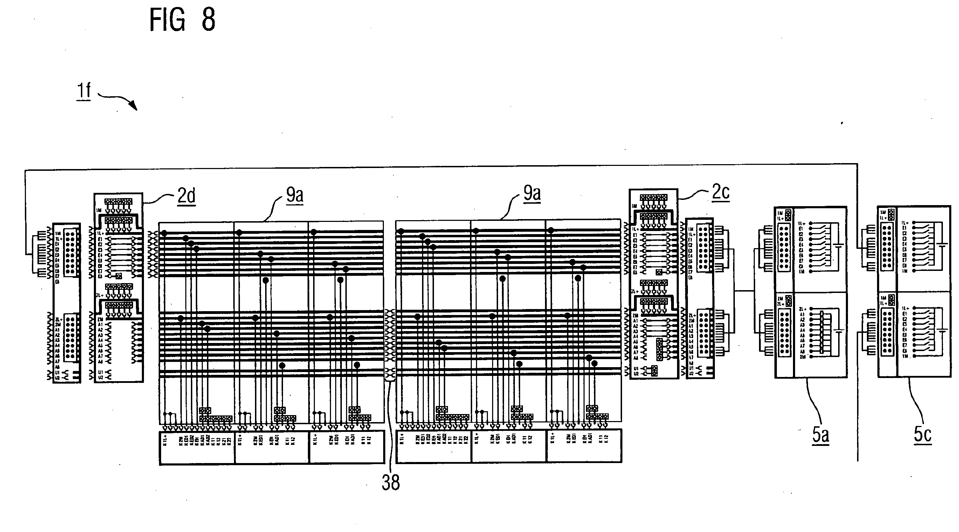

In FIG 8 ist eine vorteilhafte Ausgestaltung des Installationssystems 1f gezeigt, welches zwei baugleiche und zudem baulich verbundene Verteilungsbausteine 9a aufweist. Die beiden Verteilungsbausteine 9a sind mittels einer Steckverbindung 38 an korrespondierenden Verteilungskanälen hinsichtlich ihrer Ausgabekanäle A1 bis A8, zugehöriger Stromversorgungskanäle 2L+ und 2M sowie der Spannungsversorgungskanäle U1,U2 elektrisch leitend gekoppelt. Die dabei gegebene Verlängerung der Strombahnen ermöglicht den Anschluss von vier Direktstartern und zwei Wendestartern, die in Summe vierzehn Eingabekanäle und acht Ausgabekanäle zur Ansteuerung und Rückmeldung benötigen. Vorteilhafterweise sind neben den acht Ausgabekanälen auch die Eingabekanäle bis auf die beiden Eingabekanäle E8 belegt. An dem Verteilungsbaustein 9a und dem weiteren Verteilungsbaustein 9a ist jeweils einer der Logikbausteine 2c und 2d im Sinne der ersten und der zweiten Funktionsgruppe gemäß FIG 7 vorgesehen, so dass auch die beiden Eingabekanäle E8 nutzbar sind.

Die beiden Logikbausteine 2c und 2d weisen prinzipiell den Aufbau des Logikbausteins 2a z.B. gemäß FIG 2 auf. In einem Fall sind jedoch alle Anschlusskanäle ungebrückt, da kein Anschluss an den Verteilungskanälen des zugehörigen Verteilungsbausteins 9a vorgesehen ist. In dem anderen Fall sind alle Ausgabekanäle A1 bis A8 gebrückt ausgeführt. Die elektrisch leitende Verbindung zwischen dem Logikbaustein 2c und dem Versorgungsbaustein 5a ist z.B. gemäß FIG 2 ausgeführt. Dasselbe gilt für die Ansteuerung des Logikbausteins 2d, der mit dem Versorgungsbaustein 5c verbunden ist, wobei lediglich acht Eingabekanäle benötigt werden. Die weiteren acht Eingabekanäle des Versorgungsbausteins 5c stehen ebenso wie der jeweilige Eingabekanal E8 der Logikbausteine 2a z.B. gemäß FIG 7 sowie 2c und 2d z.B. gemäß FIG 8 zur freien Nutzung zur Verfügung, so dass durch diesen Aufbau und das dadurch gegebene Durchschleifen der Signale vorteilhafterweise die Anzahl der freien Eingabe- und Ausgabekanäle gegenüber einem Aufbau mit zwei getrennten Funktionsgruppen reduziert ist.

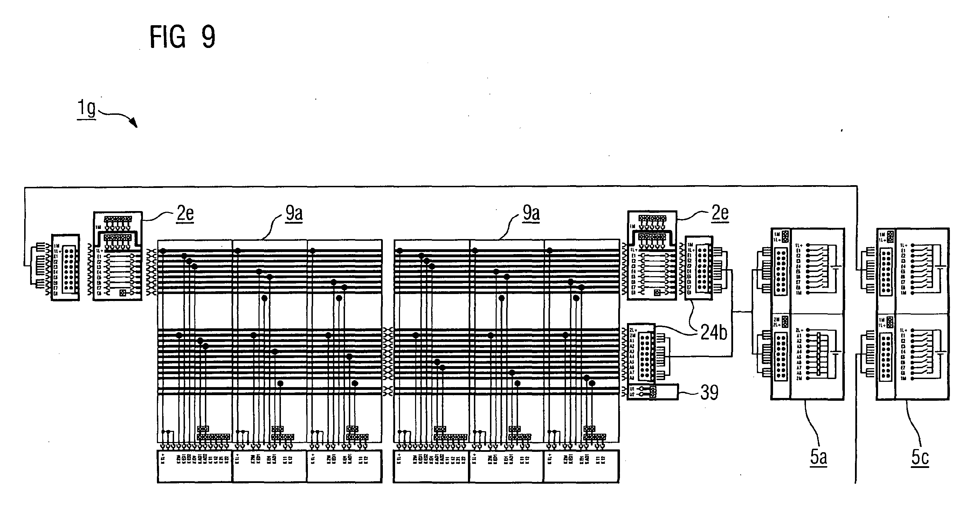

In FIG 9 ist eine vorteilhafte Ausführungsvariante des Installationssystems 1g gezeigt, die sich von der Ausführungsvariante gemäß FIG 8 dadurch unterscheidet, dass an Stelle der beiden Logikbausteine 2c und 2d nach FIG 8 in ihrer Kanalanzahl reduzierte Logikbausteine 2e eingesetzt sind. Die Logikbausteine 2e sind hierbei an den jeweiligen Eingabekanälen E1 bis E8 und an einem der Stromversorgungskanäle 1L+ der Verteilungsbausteine 9a angeschlossen. Die elektrisch leitende Verbindung zwischen dem Logikbaustein 2e und dem Versorgungsbaustein 5a ist prinzipiell z.B. gemäß FIG 2 ausgeführt, wobei jedoch ein zweigeteiltes Anschlussmodul 24b zum Einsatz kommt. Der erste Teil ist mit dem Logikbaustein 2e und der zweite Teil ist direkt mit dem Verteilungsbaustein 9a verbunden. Die Kontaktierung der Spannungsversorgungskanäle U1 und U2 ggf. ist mittels eines separaten Moduls 39 erzielbar.. Der Anschluss des Logikbausteins 2e an den Versorgungsbaustein 5c ist z.B. gemäß FIG 8 ausgeführt. Die weiteren acht Eingabekanäle des Versorgungsbausteins 5c stehen vorteilhafterweise ebenso wie der jeweilige Eingabekanal E8 der Logikbausteine 2e zur freien Belegung zur Verfügung. Durch die Unterteilung fallen die Module klein und kostengünstig aus und können bedarfsgerecht eingesetzt werden, so dass keine Überkapazitäten entstehen.

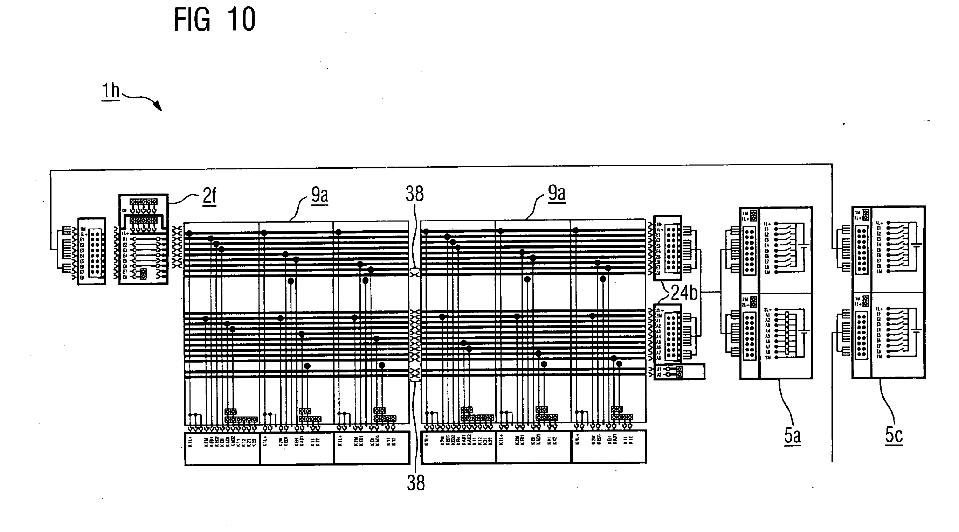

In FIG 10 ist ein weitere vorteilhafte Ausgestaltung des Installationssystems 1h gezeigt, die auf der Ausführungsvariante gemäß FIG 9 basiert. Ein erster Unterschied besteht darin, dass das zweigeteilte Anschlussmodul 24b sowohl auf der Eingabekanalebene als auch auf der Ausgabekanalebene direkt an den Verteilungskanälen des Verteilungsbausteins 9a angeschlossen ist, so dass der eine Logikbaustein 2e gemäß FIG 9 eingespart werden kann. Die beiden Verteilungsbausteine 9a weisen darüber hinaus u.a. für den Eingabekanal E8 die Steckverbindung 38 auf, mittels derer einzelne oder mehrere Eingabe- und/oder Ausgabekanäle der Verteilungsbausteine 9a verlängerbar sind. Ein weiterer Unterschied ist dadurch gegeben, dass an Stelle des Logikbausteins 2e gemäß FIG 9 bei vorliegendem Ausführungsbeispiel der Logikbaustein 2f angeschlossen ist, bei dem die Eingabekanäle E7 und E8 für eine Kontaktierung externer Mittel vorgesehen sind. Selbstverständlich können die Verschaltungsvarianten gemäß den FIG 4.1 bis 4.6 und die Ausbildungen der Verteilungsbausteine gemäß der FIG 5,6 auch bei den Ausführungen gemäß der FIG 7 bis 10 eingesetzt werden.

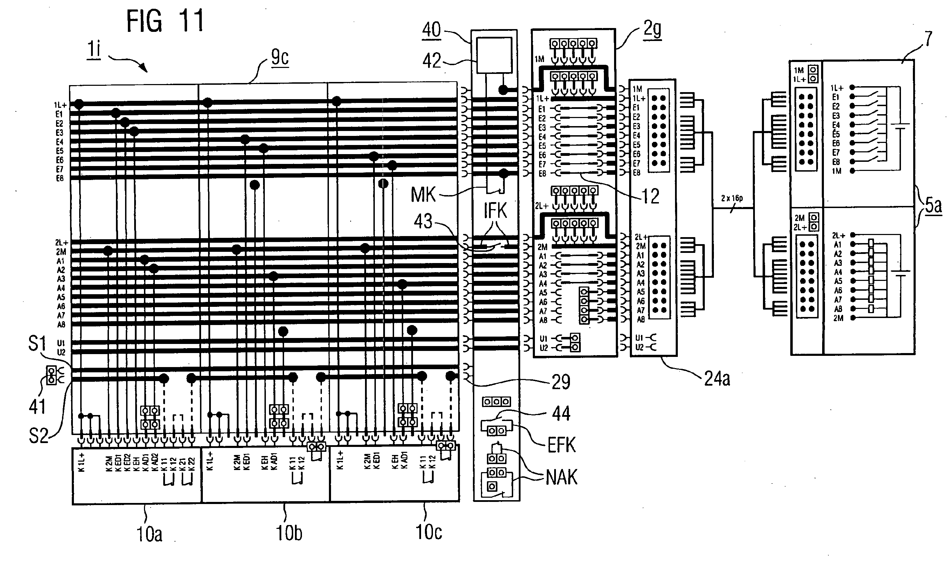

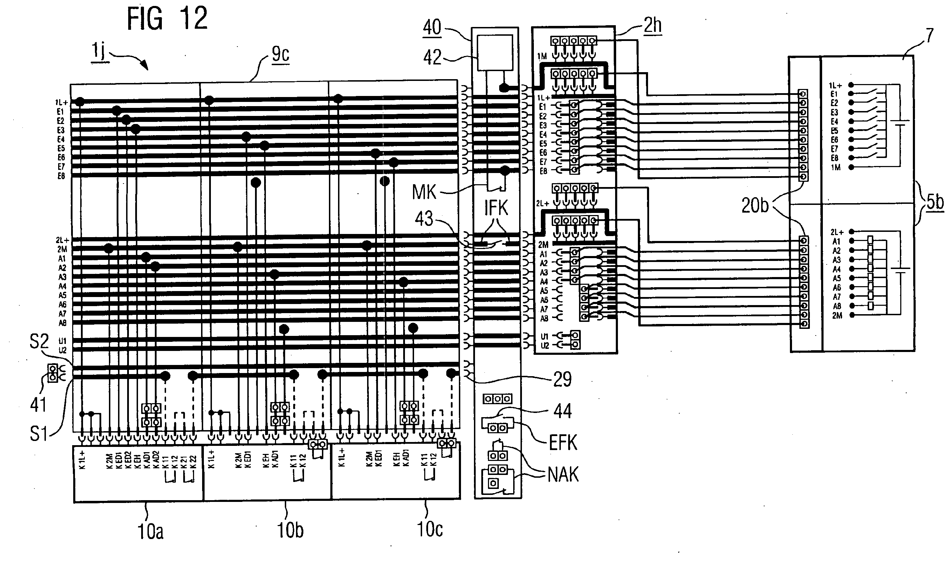

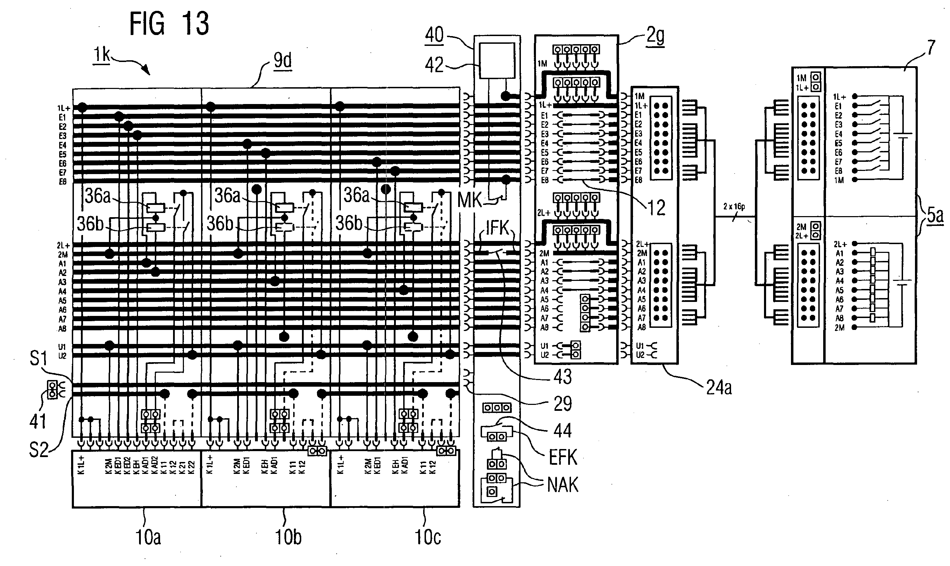

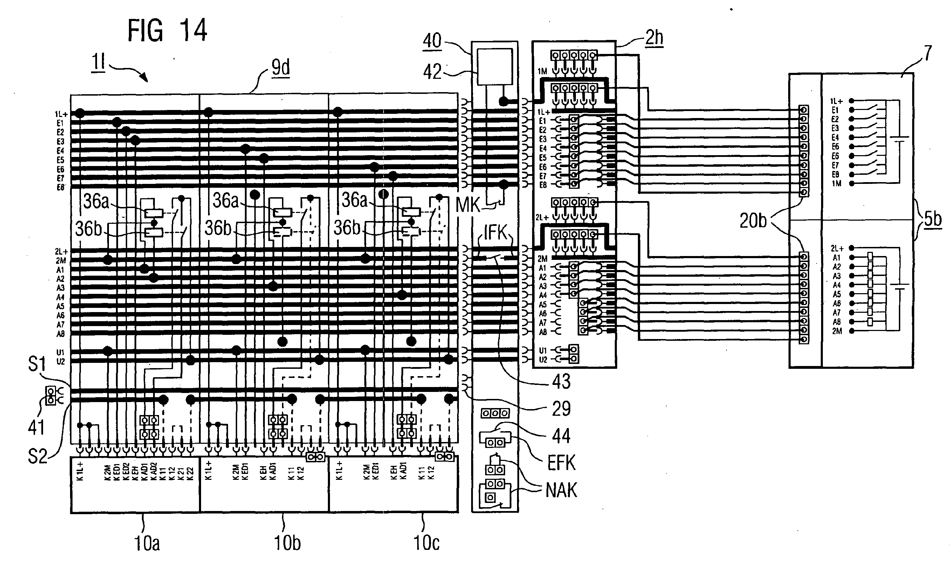

In den FIG 11 bis 14 sind vorteilhafte Ausgestaltungen des Installationssystems 1i bis 11 gezeigt, die jeweils eine dritte Vorrichtung, insbesondere Auswertungsbaustein 40, aufweisen. Der Auswertungsbaustein 40 ist mit einer vorgebbaren Anzahl von Auswertungskanälen zwischen dem Verteilungsbaustein 9c,9d und dem Logikbaustein 2g,2h über eine Steckschnittstelle angeschlossen. Der Logikbaustein 2g gemäß FIG 11 und FIG 13 ist z.B. entsprechend dem Logikbaustein 2a gemäß FIG 2 ausgeführt, wobei auch der achte Eingabekanal E8 mit einer Brücke 12 versehen ist. Gleiches gilt sinngemäß für den Logikbaustein 2h gemäß FIG 12 und FIG 14, der z.B. auf dem Logikbaustein 2b gemäß FIG 3 basiert.

Dementsprechend ist bei den FIG 11 und 13 beispielsweise gemäß FIG 2 eine indirekte Verdrahtung mittels des Anschlussmoduls 24a im Sinne eines Adapters zur Weiterführung der jeweiligen Kanäle gegeben. Weiterhin ist bei den Ausführungen gemäß FIG 12 und FIG 14 ein unmittelbarer Anschluss durch die Anschlusselemente 20b z.B. gemäß FIG 3 vorgesehen.

Die vorteilhaften Ausprägungen der Verteilungsbausteine 9c und 9d gemäß der FIG 11 und 12 bzw. 13 und 14 weisen jeweils einen Sicherheitsstromkreis mit Sicherheitskanälen S1,S2 und bausteinendseitig jeweils eine Stromkreisbrücke 41, insbesondere Klemme, auf. Die Stromkreisbrücke 41 dient zum einen als Verbindungsstück bzw. zum anderen als Platzhalter für einzubindende externe Schaltgeräte. Der Sicherheitskanal S2 ist über die Kontakte K11, K12 und ggf. K21 und K22 der jeweiligen Hilfsöffner der Funktionsbausteine 10a bis 10c geschleift. An den Funktionsbausteinen 10b und 10c, welche die Funktionsgruppe bilden, sind zudem externe Hilfsschalter in den Sicherheitsstromkreis - auch Rückführkreis genannt - integrierbar. Die Sicherheitskanäle S1 und S2 sind abschließend auf Kontaktstellen 29 des Auswertungsbausteins 40 geführt, der mittels einer Auswertungseinheit 42 die Funktionsbausteine 10a bis 10c, insbesondere Schaltgeräte, auf Betriebssicherheit überwacht.

Zur Betriebssicherheit zählt u.a. die Schaltfunktion eines Schützes der Funktionsbausteine 10a bis 10c. Der in dem Schütz integrierte Hilfsöffner ist als zwangsgeführter Kontakt ausgebildet, wobei dessen Schaltzustand von dem Auswertungsbaustein 40 abgefragt wird. Sofern die Funktionsbausteine 10a bis 10c, insbesondere die jeweiligen Schütze, nicht mit Spannung beaufschlagt und die Hilfsöffner demnach zwangsläufig geschlossen sind, gibt der Auswertungsbaustein 40 die Funktionsgruppe zum Einschalten über einen internen Freigabekreis IFK frei.

Neben dem internen Freigabekreis IFK, der einen Hilfsschließer 43 zur Freigabe der jeweiligen Schütze aufweist, ist ein internen Freigabekreis EFK, insbesondere potentialfrei, als Teil des Auswertungsbausteins 40 vorgesehen. Der externe Freigabekreis EFK dient mittels eines weiteren Hilfsschließers 44 zur Freigabe weiterer Schaltgeräte, die extern anordbar sind. Sowohl der interne als auch der externe Freigabekreis IFK bzw. EFK werden synchron von der Auswertungseinheit 42 - hier als Elektronikmodul ausgeführt - beaufschlagt. Neben dem Sicherheitsstromkreis ist ein zweikanaliger NOT-AUS-Kreis NAK für den Auswertungsbaustein 40 vorgesehen.

Wird ein NOT-AUS-Befehl über einen der beiden NOT-AUS-Kanäle, beispielsweise mittels eines NOT-AUS-Schalters, generiert, wird dieser Zustand von der Auswertungseinheit 42 erfasst. Die Auswertungseinheit 42 wirkt auf den Hilfsschließer 43 und auf den weiteren Hilfsschließer 44 des internen und des externen Freigabekreis IFK und EFK ein, so dass diese geöffnet werden. Der Hilfsschließer 43 des internen Freigabekreises IFK ist vorteilhafterweise in einem der Auswertungskanäle - hier der Massekanal - eingebunden, der zur Durchführung des Stromversorgungskanals 2M dient. Die u.a. von dem Stromversorgungskanal 2M gespeisten Funktionsbausteine 10a bis 10c werden demzufolge durch die Stromkreisunterbrechung inaktiv geschaltet. Die Auswertungseinheit 42 erfasst die Zustandsänderung in dem Sicherheitsstromkreis und gibt mittels eines internen Meldekreises MK ein Meldesignal über einen mit dem Eingabekanal E8 korrespondierenden Auswertungskanal an den Versorgungsbaustein 5a,5b insbesondere an dessen Eingabebaustein 7, aus.

In den FIG 13 und 14 weisen die jeweiligen Verteilungsbausteine 9d in einer vorteilhaften Ausgestaltung ebenfalls die Koppelrelais 36a,36b z.B. gemäß der FIG 5 und 6 auf. Selbstverständlich können die Verschaltungsvarianten gemäß den FIG 4.1 bis 4.6 auch bei den Ausführungen gemäß FIG 13,14 eingesetzt werden.

Die zuvor erläuterte Erfindung kann wie folgt zusammengefasst werden:

Um ein Installationsgerät und ein Installationssystem 1,1a-1l mit zumindest einem Installationsgerät 2,2a-2h anzugeben, die jeweils bei anschließbaren Vorrichtungen mit einer gegebenen Anzahl von Strombahnen eine rationelle Verdrahtung mit einfachen Mitteln gewährleisten, ist vorgesehen, dass das Installationsgerät 2,2a-2h an seitenverschiedenen Anschlusskanälen mit einer Vorrichtung 5,5a-5d, einer weiteren Vorrichtung 9,9a-9d bzw. einer dritten Vorrichtung 40 mit einer jeweils vorgebbaren Anzahl von Strombahnen kontaktierbar ist, wobei mittels einer Geräteeinheit 11 der Stromfluss in zumindest einem der Strombahnen 1L+,1M, E1-E8 bzw. 2L+,2M, A1-A8 beeinflussbar ist.

## Patentansprüche

1. Installationsgerät, insbesondere Logikbaustein (2,2a-2h),
- mit einer vorgebbaren Anzahl von Strombahnen, insbesondere Anschlusskanälen (1L+,1M, E1-E8 bzw. 2L+,2M, A1-A8), die sowohl an einer ersten Gerätestelle (3) als auch an einer zweiten Gerätestelle (4) kontaktierbar und jeweils für einen Stromfluss vorgesehen sind;
- wobei an einer der Gerätestellen (3 bzw. 4) an den Anschlusskanälen (1L+,1M, E1-E8 bzw. 2L+,2M, A1-A8) eine Vorrichtung, insbesondere Versorgungsbaustein (5, 5a-5d) , mit einer vorgebbaren Anzahl von Strombahnen, insbesondere Versorgungskanälen (1L+,1M, E1-E8 bzw. 2L+,2M, A1-A8), anschließbar ist;
- wobei an der jeweils anderen Gerätestelle (4 bzw. 3) an den Anschlusskanälen (1L+,1M, E1-E8 bzw. 2L+,2M, A1-A8) eine weitere Vorrichtung, insbesondere Verteilungsbaustein (9,9a-9d), bzw. eine dritte Vorrichtung, insbesondere Auswertungsbaustein (40), mit einer jeweils vorgebbaren Anzahl von Strombahnen, insbesondere Verteilungskanälen bzw. Auswertungskanälen (1L+,1M, E1-E8 bzw. 2L+,2M, A1-A8), anschließbar ist;
- mit einer Geräteeinheit (11), mittels der der Stromfluss in zumindest einem der Strombahnen, insbesondere Anschlusskanäle (1L+,1M, E1-E8 bzw. 2L+,2M, A1-A8), beeinflussbar ist.

2. Installationsgerät nach Anspruch 1,
mit einer Ausgestaltung der Geräteeinheit (11) als Schnittstelle, derart dass zumindest einer der Anschlusskanäle (1L+,1M, E1-E8 bzw. 2L+,2M, A1-A8) mittels einer elektrisch leitenden Brücke (12) durchführbar bzw. unterbrechbar ist.

3. Installationsgerät nach Anspruch 1 und/oder 2,
mit Kontaktstellen (26) zur Kontaktierung der Brücke (12) bzw. zur Kontaktierung von Anschlussmitteln (25) für zumindest einen der Anschlusskanäle (1L+,1M, E1-E8 bzw. 2L+,2M, A1-A8).

4. Installationsgerät nach Anspruch 3,
mit einer elektrisch leitenden Verbindung (33) zwischen einer Kontaktstelle (26) eines gebrückten Anschlusskanals und zumindest einer Kontaktstelle (26) eines ungebrückten Anschlusskanals.

5. Installationsgerät nach Anspruch 1,
mit weiteren Kontaktstellen (29) zur Kontaktierung einer der Versorgungskänale (1L+,1M, E1-E8 bzw. 2L+,2M, A1-A8) einerseits und einer der Verteilungskanäle (1L+,1M, E1-E8 bzw. 2L+,2M, A1-A8) andererseits für zumindest einen der Anschlusskanäle (1L+,1M, E1-E8 bzw. 2L+,2M, A1-A8).

6. Installationsgerät nach Anspruch 1,
mit zumindest einem Kontaktstellenpaar (27a-27c) zur Kontaktierung weiterer Anschlussmittel (28a-28c), über die verschiedene Versorgungsspannungen einspeisbar bzw. abgreifbar sind.

7. Installationsgerät nach Anspruch 3,5 und/oder 6,
mit einer modularen, abnehmbaren Ausbildung der Anschlussmittel (25) und/oder der weiteren Anschlussmittel (28a-28c).

8. Installationsgerät nach einem der Ansprüche 6 oder 7,
mit einer Ausbildung der Kontaktstellen (26) bzw. des Kontaktstellenpaars (27a-27c) bzw. der weiteren Kontaktstellen (29) als Steck- und/oder Klemmkontakte.

9. Installationsgerät nach Anspruch 3 und/oder 6,
mit einem Funktionselement (34), das zwischen zumindest einem der Kontaktstellen des Kontaktstellenpaares (27a-27c) und einer der Kontaktstellen (26) eines ungebrückten Anschlusskanals (1L+,1M, E1-E8 bzw. 2L+,2M, A1-A8) anschließbar ist.

10. Installationsgerät nach Anspruch 3 und/oder 9,
mit einem Anschluss des Funktionselements (34) zwischen Kontaktstellen (26) eines ungebrückten Anschlusskanals (1L+,1M, E1-E8 bzw. 2L+,2M, A1-A8).

11. Installationsgerät nach Anspruch 3,6 und/oder 9,
mit einem Anschluss des Funktionselements (34) zwischen einem der Kontaktstellen des Kontaktstellenpaares (27a-27c) und einem der Kontaktstellen (26) eines gebrückten Anschlusskanals (1L+,1M, E1-E8 bzw. 2L+,2M, A1-A8).

12. Installationsgerät nach Anspruch 3 und/oder 6,
mit einem Anzeigemittel (35), das zwischen einem der Kontaktstellen des Kontaktstellenpaares (27a-27c) und einer elektrisch leitenden Verbindung (33), die seitengleiche Kontaktstellen (26) verschiedener ungebrückter Anschlusskanäle (1L+,1M, E1-E8 bzw. 2L+,2M, A1-A8) kontaktiert, anschließbar ist.

13. Installationsgerät nach Anspruch 3,6 und/oder 9,
mit einem Anschluss des Anzeigemittels (35) zwischen einem der Kontaktstellen des Kontaktstellenpaares (27a-27c) und einem der Kontaktstellen (26) eines gebrückten Anschlusskanals (1L+,1M, E1-E8 bzw. 2L+,2M, A1-A8).

14. Installationssystem
- mit zumindest einem Installationsgerät, insbesondere Logikbaustein (2,2a-2h), welches eine vorgebbare Anzahl von Strombahnen, insbesondere Anschlusskanälen (1L+,1M, E1-E8 bzw. 2L+,2M, A1-A8), aufweist, die sowohl an einer ersten Gerätestelle (3) als auch an einer zweiten Gerätestelle (4) kontaktierbar und jeweils für einen Stromfluss vorgesehen sind;
- mit einer an einer der Gerätestellen (3 bzw. 4) an den Anschlusskanälen (1L+,1M, E1-E8 bzw. 2L+,2M, A1-A8) anschließbaren Vorrichtung, insbesondere Versorgungsbaustein (5,5a-5d), die eine vorgebbare Anzahl von Strombahnen, insbesondere Versorgungskanälen (1L+,1M, E1-E8 bzw. 2L+,2M, A1-A8), aufweist;
- mit einer an der jeweils anderen Gerätestelle (4 bzw. 3) an den Anschlusskanälen (1L+,1M, E1-E8 bzw. 2L+,2M, Al-A8) anschließbaren weiteren Vorrichtung, insbesondere Verteilungsbaustein (9,9a-9d), die eine vorgebbare Anzahl von Strombahnen, insbesondere Verteilungskanälen (1L+,1M, E1-E8 bzw. 2L+,2M, A1-A8), aufweist;
- mit einer Geräteeinheit (11), mittels der der Stromfluss in zumindest einem der Strombahnen, insbesondere Anschlusskanälen (1L+,1M, E1-E8 bzw. 2L+,2M, A1-A8), beeinflussbar ist.

15. Installationssystem nach Anspruch 14,
mit einer zwischen dem Installationsgerät mit Anschlusskanälen und der weiteren Vorrichtung mit Verteilungskanälen anschließbaren dritten Vorrichtung, insbesondere Auswertungsbaustein (40), die eine vorgebbare Anzahl von Auswertungskanälen (1L+,1M, E1-E8 bzw. 2L+,2M, A1-A8) aufweist.

16. Installationssystem nach Anspruch 14,
mit einer Ausgestaltung der Geräteeinheit (11) als Schnittstelle, derart dass zumindest einer der Anschlusskanäle mittels einer elektrisch leitenden Brücke (12) durchführbar bzw. unterbrechbar ist.

17. Installationssystem nach Anspruch 14 und/oder 16,
mit Kontaktstellen (26) zur Kontaktierung der Brücke (12) bzw. zur Kontaktierung von Anschlussmitteln (25) für zumindest einen der Anschlusskanäle (1L+,1M, E1-E8 bzw. 2L+,2M, A1-A8).

18. Installationssystem nach Anspruch 17,
mit einer elektrisch leitenden Verbindung (33) zwischen einer Kontaktstelle (26) eines gebrückten Anschlusskanals (1L+,1M, E1-E8 bzw. 2L+,2M, A1-A8) und zumindest einer Kontaktstelle (26) eines ungebrückten Anschlusskanals (1L+,1M, E1-E8 bzw. 2L+,2M, A1-A8).

19. Installationssystem nach Anspruch 14,
mit weiteren Kontaktstellen (29) zur Kontaktierung einer der Versorgungskänale (1L+,1M, E1-E8 bzw. 2L+,2M, A1-A8) einerseits und einer der Verteilungskanäle (1L+,1M, E1-E8 bzw. 2L+,2M, A1-A8) andererseits für zumindest einen der Anschlusskanäle (1L+,1M, E1-E8 bzw. 2L+,2M, A1-A8).

20. Installationssystem nach Anspruch 14,
mit zumindest einem Kontaktstellenpaar (27a-27c) zur Kontaktierung weiterer Anschlussmittel (28a-28c), über die verschiedene Versorgungsspannungen einspeisbar bzw. abgreifbar sind.

21. Installationssystem nach Anspruch 17 und/oder 18,
mit einer modularen, abnehmbaren Ausbildung der Anschlussmittel (25) und/oder der weiteren Anschlussmittel (28a-28c).

22. Installationssystem nach einem der Ansprüche 19,20 und/oder 21,
mit einer Ausbildung der Kontaktstellen (26) bzw. des Kontaktstellenpaars (27a-27c) bzw. der weiteren Kontaktstellen (29) als Steck- und/oder Klemmkontakte.

23. Installationssystem nach Anspruch 16 und/oder 20,
mit einem Funktionselement (34), das zwischen zumindest einem der Kontaktstellen des Kontaktstellenpaares (27a-27c) und einer der Kontaktstellen (26) eines ungebrückten Anschlusskanals (1L+,1M, E1-E8 bzw. 2L+,2M, A1-A8) anschließbar ist.

24. Installationssystem nach Anspruch 17 und/oder 23,
mit einem Anschluss des Funktionselements (34) zwischen Kontaktstellen (26) eines ungebrückten Anschlusskanals (1L+,1M, E1-E8 bzw. 2L+,2M, A1-A8).

25. Installationssystem nach Anspruch 17,20 und/oder 23,
mit einem Anschluss des Funktionselements (34) zwischen einem der Kontaktstellen des Kontaktstellenpaares (27a-27c) und einem der Kontaktstellen (26) eines gebrückten Anschlusskanals (1L+,1M, E1-E8 bzw. 2L+,2M, A1-A8).

26. Installationssystem nach Anspruch 17 und/oder 20,
mit einem Anzeigemittel (35), das zwischen einem der Kontaktstellen des Kontaktstellenpaares (27a-27c) und einer elektrisch leitenden Verbindung (33), die seitengleiche Kontaktstellen (26) verschiedener ungebrückter Anschlusskanäle (1L+,1M, E1-E8 bzw. 2L+,2M, A1-A8) kontaktiert, anschließbar ist.

27. Installationssystem nach Anspruch 17,20 und/oder 23,
mit einem Anschluss des Anzeigemittels (35) zwischen einem der Kontaktstellen des Kontaktstellenpaares (27a-27c) und einem der Kontaktstellen (26) eines gebrückten Anschlusskanals (1L+,1M, E1-E8 bzw. 2L+,2M, A1-A8).

28. Installationssystem nach Anspruch 14 und/oder 15,
mit einer an dem Versorgungsbaustein (5,5a-5d) angeordneten Anschlusseinheit (21,22), die über eine Leitung (23) mit einem an dem Logikbaustein (2,2a-2h) und/oder an dem Verteilungsbaustein (9,9a-9d) und/oder an dem Auswertungsbaustein (40) angeordneten Anschlussmodul (24a,24b) im Sinne eines Adapters zur Weiterführung der jeweiligen Kanäle (1L+,1M, E1-E8 bzw. 2L+,2M, A1-A8) elektrisch leitend verbunden ist.

29. Installationssystem nach Anspruch 17 und/oder 28,
mit einer Ausbildung der Anschlusseinheit (21,22) mit Anschlusselementen (20a,20b), welche über die Leitung (23) unmittelbar mit den Anschlussmitteln (25) des Logikbausteins (2,2a-2h) und/oder des Verteilungsbausteins (9,9a-9d) und/oder des Auswertungsbausteins (40) elektrisch leitend verbunden sind.

30. Installationssystem nach Anspruch 30 und/oder 29,
mit einer vorkonfektionierten Ausgestaltung der Leitung (23) und/oder der Anschlusseinheit (21,22) und/oder des Anschlussmoduls (24a,24b).

31. Installationssystem nach Anspruch 14 und/oder 20,
mit zumindest einem dem Verteilungsbaustein (9,9a-9d) zuordbaren und an dessen Verteilungskanälen (1L+,1M, E1-E8 bzw. 2L+,2M, A1-A8) anschließbaren Koppelrelais (36a,36b), das zur Beaufschlagung zumindest eines Funktionsbausteins (10a-10c) mit einer der Versorgungsspannungen vorgesehen ist.

32. Installationssystem nach Anspruch 31,
mit einer rasterfreien Anordnung zumindest eines der Funktionsbaustein (10a-10c) an den Verteilungskanälen (1L+,1M, E1-E8 bzw. 2L+,2M, A1-A8).

33. Installationssystem nach Anspruch 14 und/oder 31,
mit zumindest einem an dem Verteilungsbaustein (9,9a-9d) koppelbaren weiteren Verteilungsbaustein (9,9a-9d).

34. Installationssystem nach Anspruch 14 und/oder 31,
mit einem in dem Verteilungsbaustein (9,9a-9d) integrierten Not-Aus-Kreis (NAK) und/oder Sicherheitsstromkreis für einen oder mehrere Schalter.

35. Installationssystem nach Anspruch 14 und/oder 34,
mit einer in dem Auswertungsbaustein (40) integrierten Auswertungseinheit (42), die in Abhängigkeit des Not-Aus-Kreises (NAK) und/oder des Sicherheitsstromkreis einen Meldekreis (MK) und/oder einen internen Freigabekreis (IFK) und/oder einen externen Freigabekreis (EFK) beeinflusst.
